(19) Europäisches Patentamt
European Patent Office
Office européen des brevets

(11) **EP 3 108 554 B1**

(12) **EUROPÄISCHE PATENTSCHRIFT**

(45) Veröffentlichungstag und Bekanntmachung des Hinweises auf die Patenterteilung:
**13.12.2017 Patentblatt 2017/50**

(21) Anmeldenummer: **14714982.7**

(22) Anmeldetag: **28.03.2014**

(51) Int Cl.:
*H02H 7/045* (2006.01)  *H02H 7/06* (2006.01)
*H02H 3/26* (2006.01)  *H02H 3/32* (2006.01)
*G01R 31/40* (2014.01)  *G01R 31/02* (2006.01)

(86) Internationale Anmeldenummer:
**PCT/EP2014/056284**

(87) Internationale Veröffentlichungsnummer:
**WO 2015/144235 (01.10.2015 Gazette 2015/39)**

(54) **DIFFERENTIALSCHUTZVERFAHREN UND DIFFERENTIALSCHUTZEINRICHTUNG**

DIFFERENTIAL PROTECTION METHOD AND DIFFERENTIAL PROTECTION DEVICE

PROCÉDÉ DE PROTECTION DE DIFFÉRENTIEL ET DISPOSITIF DE PROTECTION DE DIFFÉRENTIEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.12.2016 Patentblatt 2016/52**

(73) Patentinhaber: **Siemens Aktiengesellschaft 80333 München (DE)**

(72) Erfinder:
• **SCHIEL, Ludwig 10627 Berlin (DE)**
• **REBIZANT, Waldemar PL-53/678 Wroclaw (PL)**
• **WISZNIEWSKI, Andrzej PL-51-144 Wroclaw (PL)**

(56) Entgegenhaltungen:
**WO-A1-2010/034635  US-A- 5 808 844**

**Beschreibung**

Die Erfindung betrifft ein Differentialschutzverfahren zum Erzeugen eines Fehlersignals, das einen im Bereich einer elektrischen Komponente eines Energieversorgungsnetzes aufgetretenen Fehler angibt, bei dem an mindestens zwei unterschiedlichen Messstellen der Komponente jeweils Strommesswerte gemessen werden und mit den Strommesswerten Differenzstromwerte und Stabilisierungswerte gebildet werden, und das Fehlersignal erzeugt wird, wenn im Rahmen einer Auslösebereichsprüfung festgestellt wird, dass ein aus einem der Differenzstromwerte und dem jeweils zugehörigen Stabilisierungswert gebildetes Messwertpaar in einem vorgegebenen Auslösebereich liegt. Die Erfindung betrifft auch eine Differentialschutzeinrichtung mit einer Messwerterfassungseinrichtung zur Erfassung von an unterschiedlichen Stellen einer elektrischen Komponente eines Energieversorgungsnetzes ermittelten Strommesswerten, und mit einer Auswerteeinrichtung, die zur Bildung von Differenzstromwerten und Stabilisierungswerten aus den Strommesswerten und zur Erzeugung eines Fehlersignals eingerichtet ist, wenn im Rahmen einer Auslösebereichsprüfung festgestellt wird, dass ein aus einem der Differenzstromwerte und dem jeweils zugehörigen Stabilisierungswert gebildetes Messwertpaar in einem vorgegebenen Auslösebereich liegt.

Ein solches Differentialschutzverfahren und ein solches Differentialschutzgerät sind beispielsweise aus dem Produkthandbuch des Differentialschutzgerätes SIPROTEC 7UT6x "SIPROTEC - Differential Protection 7UT6x, V4.6, Siemens AG 2013, Bestellnummer C53000-1176-C230-3" bekannt. Bei dem bekannten Differentialschutzgerät werden Strommesswerte an zwei Messstellen einer elektrischen Komponente, z.B. auf der Ober- und der Unterspannungsseite eines Transformators, erfasst und daraus Differenzstromwerte und Stabilisierungsstromwerte ermittelt. Anhand der Lage des aus einem Differenzstromwert und einem zugehörigen Stabilisierungsstromwert gebildeten Messwertpaares in einem Diagramm wird auf das Vorliegen eines Fehlers, z.B. eines Kurzschlusses, geschlossen und ein entsprechendes Fehlersignal erzeugt. Bei vorliegendem Fehlersignal wird letztlich ein Schalter zum Öffnen seiner Schaltkontakte veranlasst, um die fehlerbehaftete Komponente von dem elektrischen Energieversorgungsnetz abzutrennen. Außerdem sind ein solches Differentialschutzverfahren und ein solches Differentialschutzgerät auch aus der US 5 808 844 A bekannt.

Außerdem ist es beim Differentialschutz für Transformatoren bekannt, zur Erhöhung der Zuverlässigkeit von Entscheidungen über das Vorliegen eines Fehlers im Bereich einer elektrischen Komponente die beschriebene Differentialschutzfunktion durch weitere Zusatzalgorithmen zu stabilisieren. Diese Zusatzalgorithmen dienen zur Erkennung bestimmter Betriebszustände des Energieversorgungsnetzes und blockieren bei Erkennung eines solchen Betriebszustandes die Erzeugung des Fehlersignals. Hierdurch wird erreicht, dass das Fehlersignal zuverlässig nur bei tatsächlichem Vorliegen eines Fehlers erzeugt wird. Die erwähnten bestimmten Betriebszustände des Energieversorgungsnetzes können beispielsweise Einschaltvorgänge im Energieversorgungsnetz, das Auftreten bestimmter harmonischer Schwingungen bezüglich Strom und/oder Spannung im Energieversorgungsnetz, das Vorliegen besonders stromstarker externer Fehler (also Fehler, die außerhalb des Bereichs der überachten Komponente liegen, teilweise aber ein ähnliches Verhalten wie interne Fehler aufzeigen) oder eine auftretende Wandlersättigung umfassen. Beispielsweise ist aus der WO 2010/034635 A1 ein Verfahren bekannt, mit dem ein Einschaltvorgang in einem Energieversorgungsnetz anhand bestimmter charakteristischer Muster im Verlauf der Phasenströme erkannt wird (sogenannte "In-Rush-Detection") und bei Vorliegen eines Einschaltvorgangs die Erzeugung eines Fehlersignals blockiert wird. Ein weiteres Verfahren zur Erkennung eines vorliegenden Einschaltvorgangs ist beispielsweise aus der IEEE-Veröffentlichung "A new method to identify inrush current based on error estimation", He B., Zhang X., Bo Z., IEEE Transactions on Power Delivery, Band 21, Nr. 3, Juli 2006, Seiten 1163-1168, bekannt. Ein auf Anwendung einer Fuzzy-Logik basierendes Verfahren zur Erkennung unterschiedlichster Systemzustände ist außerdem aus der IEEE-Veröffentlichung " A self-organizing fuzzy logic based protective relay-an application to power transformer protection", Kasztenny, B., Rosolowski, E, Saha, M.M., Hillstrom, B., IEEE Transactions on Power Delivery, Band 12, Nr. 3, Juli 1997, Seiten 119-1127 bekannt.

Durch Hinzufügen immer weiterer Betriebszustände, bei denen die Erzeugung eines Fehlersignals zu blockieren ist, und entsprechender Zusatzalgorithmen erhöht sich zwangsläufig sowohl die Komplexität einer zur Durchführung der entsprechenden Algorithmen eingesetzten Differentialschutzeinrichtung als auch die Anzahl der von einem Betreiber einer solchen Differentialschutzeinrichtung einzustellender Parameter. Mit steigender Komplexität und Parameteranzahl erhöht sich zudem die Wahrscheinlichkeit von Fehlfunktionen und/oder Fehleinstellungen, wodurch die Funktionsfähigkeit der Differentialschutzeinrichtung insgesamt beeinträchtigt wird.

Beim Differentialschutz von Generatoren werden bisher üblicherweise keine Zusatzalgorithmen zur Stabilisierung gegen Einschaltvorgänge eingesetzt. Eine Zusatzstabilisierung zur Erkennung externer Fehler wird zwar eingesetzt, aber die Kurzschlussströme sind oft derart gering, dass unter bestimmten Umständen, z.B. bei sogenannten "generatornahen Fehlern", das Risiko von Fehlentscheidungen bestehen kann.

Es ist daher eine Aufgabe der Erfindung, ein Differentialschutzverfahren anzugeben, mit dem bei vergleichsweise geringer Komplexität eine zuverlässige Erzeugung eines Fehlersignals nur bei tatsächlich im Bereich der elektrischen Komponente vorliegenden Fehlern gewährleistet werden kann. Der Erfindung liegt auch die Aufgabe zugrunde, eine entsprechend ausgebildete Differentialschutzeinrichtung anzugeben.

Hinsichtlich des Differentialschutzverfahrens wird diese Aufgabe durch ein Differentialschutzverfahren der eingangs angegebenen Art gelöst, bei dem die in einem vorgegebenen Betrachtungszeitraum liegenden Stabilisierungsstromwerte mit den jeweils zugehörigen Differenzstromwerten verglichen werden und anhand des Vergleichs ein Fehlerindikator gebildet wird, der angibt, ob der Anteil der Differenzstromwerte oder der Anteil der Stabilisierungsstromwerte überwiegt, und die Erzeugung des Fehlersignals blockiert wird, wenn der Fehlerindikator einen überwiegenden Anteil der Stabilisierungsstromwerte angibt.

Der besondere Vorteil des erfindungsgemäßen Verfahrens liegt darin, dass durch Betrachtung eines einzelnen Kriteriums zuverlässig solche Betriebszustände des elektrischen Energieversorgungsnetzes erkannt werden können, bei denen die Erzeugung eines Fehlersignals blockiert werden soll, da sie nicht auf das tatsächliche Vorliegen eines Fehlers hindeuten. Dadurch dass die Entscheidung auf Grundlage eines Fehlerindikators getroffen wird, der nicht punktuell unter Verwendung eines einzelnen Messwertpaares gebildet wird, sondern vielmehr wegen des verwendeten Betrachtungszeitraums quasi die zeitliche "Vorgeschichte" des aktuellen Messwertpaares einbezieht, kann eine sehr zuverlässige Unterscheidung von tatsächlichen im Bereich der Komponente liegenden Fehlern ("internen Fehlern") und anderen Betriebszuständen, die keine Erzeugung eines Fehlersignals erfordern, vorgenommen werden. Bei der Bildung des Fehlerindikators wird gleichsam ausgewertet, ob im Betrachtungszeitraum ein Anteil der Differenzstromwerte oder ein Anteil der Stabilisierungsstromwerte überwiegt. Ersteres deutet auf das Vorliegen eines internen Fehlers hin, während letzteres auf das Vorliegen eines anderen Betriebszustandes, bei dem die Erzeugung eines Fehlersignals blockiert werden soll, schließen lässt.

Das erfindungsgemäße Differentialschutzverfahren kann beispielsweise zur Überwachung von Transformatoren eingesetzt werden. Es kann darüber hinaus auch vorteilhaft zur Überwachung elektrischer Maschinen (Generatoren) verwendet werden. Hierbei hat sich das Verfahren insbesondere im Falle sogenannter "generatornaher externer Fehler" mit vergleichsweise niedrigen Fehlerströmen und langen Zeitkonstanten des Gleichstromanteils als zuverlässig herausgestellt.

Das erfindungsgemäße Verfahren erlaubt zudem beim Transformator-, wie auch beim Generatorschutz eine zuverlässige Unterscheidung zwischen externen Fehlern mit auftretender Wandlersättigung oder Einschaltvorgängen einerseits und internen Fehlern andererseits.

Eine vorteilhafte Weiterbildung des erfindungsgemäßen Verfahrens sieht vor, dass zur Bildung des Fehlerindikators das integrale Mittel aus unter Verwendung der Differenzstromwerte und der Stabilisierungsstromwerte gebildeten Differenzen bestimmt wird.

Gemäß dieser Ausführungsform des erfindungsgemäßen Verfahrens werden zunächst die Differenzstromwerte und die jeweils zugehörigen Stabilisierungsstromwerte dazu verwendet, um eine Differenz zu bilden, die einen Rückschluss auf den überwiegenden Anteil zulässt. Diese Differenzbildung wird über den gesamten Betrachtungszeitraum durchgeführt und es wird das integrale Mittel aller Differenzen gebildet, um den Fehlerindikator zu bestimmen.

Gemäß einer weiteren vorteilhaften Ausführungsform des erfindungsgemäßen Verfahrens kann zudem vorgesehen sein, dass als elektrische Komponente ein Transformator oder ein Generator verwendet wird.

In diesem Zusammenhang kann außerdem vorgesehen sein, dass der Fehlerindikator in Abhängigkeit von der Art der elektrischen Komponente unterschiedlich bestimmt wird.

Beispielsweise können für unterschiedliche Arten von elektrischen Komponenten bei der Bildung des Fehlerindikators unterschiedliche Wichtungsfaktoren für die Differenzstromwerte bzw. die Stabilisierungsstromwerte verwendet werden. Besonders einfach kann eine Entscheidung über eine Blockierung der Erzeugung des Fehlersignals getroffen werden, indem der Fehlerindikator mit einem vorgegebenen Schwellenwert verglichen wird, und die Erzeugung des Fehlersignals blockiert wird, wenn der Fehlerindikator den Schwellenwert unterschreitet.

In diesem Zusammenhang kann gemäß einer weiteren vorteilhaften Ausführungsform des erfindungsgemäßen Verfahrens vorgesehen sein, dass der Schwellenwert in Abhängigkeit von der Art der elektrischen Komponente unterschiedlich festgelegt wird.

Gemäß einer weiteren vorteilhaften Ausführungsform des erfindungsgemäßen Verfahrens kann zudem vorgesehen sein, dass der Fehlerindikator unter direkter Verwendung der Differenzstromwerte oder unter Verwendung von den Differenzstromwerten abgeleiteter Werte bestimmt wird.

Bei direkter Verwendung der Differenzstromwerte werden diese unmittelbar mit den zugehörigen Stabilisierungsstromwerten, beispielsweise durch Differenzbildung, verglichen. Bei Verwendung von Werten, die von den Differenzstromwerten abgeleitet sind, kann beispielsweise zunächst eine jeweilige mit der Kreisfrequenz $\omega$ des Verlaufs der Strommesswerte multiplizierte erste Ableitung der Differenzstromwerte zum Vergleich mit den Stabilisierungsstromwerten benutzt werden.

Konkret kann gemäß einer weiteren vorteilhaften Ausführungsform des erfindungsgemäßen Verfahrens vorgesehen sein, dass der Fehlerindikator wie folgt gebildet wird:

$$J(t) = \frac{1}{T_1} \cdot \int_{t-T_1}^{t} \left( i_{op} - K \cdot i_r \right) dt$$

mit

J(t) :     Fehlerindikator;
t :     Zeit;
$T_1$ :     Länge des vorgegebenen Betrachtungszeitraums;
$i_{op}$ :     aus den Differenzstromwerten gebildeter Auslösestrom;
K :     Anpassungsfaktor zur Anpassung an die Art der elektrischen Komponente;
$i_r$ :     Stabilisierungsstrom.

Wie man leicht sieht, beschreibt der Term innerhalb des Integrals den durch Differenzbildung vorgenommenen Vergleich zwischen einem auf den Differenzstromwerten basierenden Auslösestrom und den jeweiligen - über einen komponentenabhängigen Anpassungsfaktor gewichteten - Stabilisierungsstromwerten. Der Betrachtungszeitraum $T_1$ kann beispielsweise bei 20 ms (eine Periodendauer) gewählt werden. Der Anpassungsfaktor K kann beispielsweise im Fall eines Transformators als Komponente den Wert 0,3 und im Fall eines Generators als Komponente den Wert 0,7 annehmen.

Im Falle einer mehrphasigen (z.B. 3-phasigen) elektrischen Komponente wird es zudem als vorteilhaft angesehen, wenn der Fehlerindikator für jede Phase einer mehrphasigen elektrischen Komponente bestimmt wird, und die Erzeugung des Fehlersignals nur dann blockiert wird, wenn die Fehlerindikatoren für alle Phasen den vorgegebenen Schwellenwert unterschreiten.

Hierdurch kann sichergestellt werden, dass die Erzeugung eines Fehlersignals nur dann blockiert wird, wenn durch den Fehlerindikator für alle Phasen gleichermaßen ein fehlerhafter Zustand ausgeschlossen werden kann.

Die oben genannte Aufgabe wird auch durch eine Differentialschutzeinrichtung der eingangs angegebenen Art gelöst, bei der die Auswerteeinrichtung auch dazu eingerichtet ist, die in einem vorgegebenen Betrachtungszeitraum liegenden Stabilisierungsstromwerte mit den jeweils zugehörigen Differenzstromwerten zu vergleichen und anhand des Vergleichs einen Fehlerindikator zu bilden, der angibt, ob der Anteil der Differenzstromwerte oder der Anteil der Stabilisierungsstromwerte überwiegt, und die Erzeugung des Fehlersignals zu blockieren, wenn der Fehlerindikator einen überwiegenden Anteil der Stabilisierungsstromwerte angibt.

Im Zusammenhang mit der Differentialschutzeinrichtung kann zudem vorgesehen sein, dass die Auswerteeinrichtung dazu eingerichtet ist, zur Bildung des Fehlerindikators das integrale Mittel aus unter Verwendung der Differenzstromwerte und der Stabilisierungsstromwerte gebildeten Differenzen zu bestimmen.

Außerdem kann gemäß einer weiteren vorteilhaften Ausführungsform der erfindungsgemäßen Differentialschutzeinrichtung vorgesehen sein, dass die Auswerteeinrichtung dazu eingerichtet ist, den Fehlerindikator mit einem vorgegebenen Schwellenwert zu vergleichen, und die Erzeugung des Fehlersignals zu blockieren, wenn der Fehlerindikator den Schwellenwert unterschreitet.

Hinsichtlich der erfindungsgemäßen Differentialschutzeinrichtung gelten alle zu dem erfindungsgemäßen Differentialschutzverfahren voranstehend und nachfolgend gemachten Ausführungen und umgekehrt, insbesondere ist die erfindungsgemäße Differentialschutzeinrichtung zur Durchführung des erfindungsgemäßen Differentialschutzverfahrens in jeder beliebigen Ausführungsform oder einer Kombination beliebiger Ausführungsformen eingerichtet. Auch hinsichtlich der Vorteile der erfindungsgemäßen Differentialschutzeinrichtung wird auf die zu dem erfindungsgemäßen Differentialschutzverfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Differentialschutzverfahrens und der erfindungsgemäßen Differentialschutzeinrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

Figur 1          eine schematische Ansicht einer mit einer Differentialschutzeinrichtung überwachten Komponente eines elektrischen Energieversorgungsnetzes;

Figur 2                ein Ablaufschema zur Erläuterung eines Ausführungsbeispiels eines Differentialschutzverfahrens ;

Figuren 3-4        Diagramme zur Erläuterung eines ersten Ausführungsbeispiels der Auswertung von Strommesswerten mit einem Differentialschutzverfahren;

Figuren 5-6        Diagramme zur Erläuterung eines zweiten Ausführungsbeispiels der Auswertung von Strommesswerten mit einem Differentialschutzverfahren;

Figuren 7-8        Diagramme zur Erläuterung eines dritten Ausführungsbeispiels der Auswertung von Strommesswerten mit einem Differentialschutzverfahren; und

Figuren 9-10      Diagramme zur Erläuterung eines vierten Ausführungsbeispiels der Auswertung von Strommesswerten mit einem Differentialschutzverfahren.

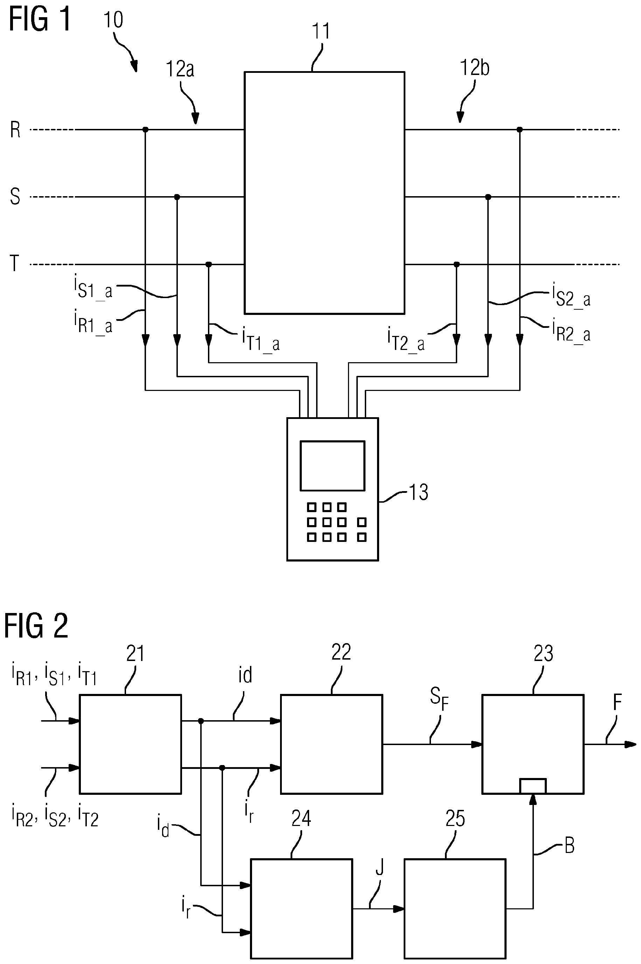

In der Figur 1 erkennt man einen Abschnitt 10 eines nicht weiter dargestellten Energieversorgungsnetzes. Der Abschnitt 10 weist eine elektrische Komponente 11 auf, bei der es sich beispielsweise um einen Transformator oder einen Generator handeln kann. Die Komponente 11 wird mittels eines nachfolgend näher erläuterten Differentialschutzverfahrens auf Fehler, wie z.B. Kurzschlüsse überwacht.

Hierzu werden für die einzelnen Phasenleiter R, S, T an einer ersten Messstelle 12a analoge Augenblickswerte der Phasenströme $i_{R1\_a}$, $i_{S1\_a}$, $i_{T1\_a}$ sowie an einer zweiten Messstelle 12b Phasenströme $i_{R2\_a}$, $i_{S2\_a}$, $i_{T2\_a}$ erfasst und einer Differentialschutzeinrichtung 13 zugeführt. Die Differentialschutzeinrichtung weist eine (in Figur 1 nicht gezeigte) Messwerterfassungseinrichtung auf, mit der die Phasenströme erfasst und durch Abtastung in entsprechende Strommesswerte $i_{R1}$, $i_{S1}$, $i_{T1}$ bzw. $i_{R2}$, $i_{S2}$, $i_{T2}$ umgesetzt werden. In Abweichung zur Darstellung gemäß Figur 1 kann die Abtastung hierbei auch bereits mittels der zur Erfassung des Stroms verwendeten Stromwandler bzw. einer diesen nachgeschalteten Abtasteinrichtung erfolgen; in diesem Fall würden bereits die abgetasteten Strommesswerte $i_{R1}$, $i_{S1}$, $i_{T1}$ bzw. $i_{R2}$, $i_{S2}$, $i_{T2}$ direkt an die Differentialschutzeinrichtung 13 übertragen werden.

Die Differentialschutzeinrichtung 13 ist mit einer (in Figur 1 ebenfalls nicht gezeigten) Auswerteeinrichtung ausgestattet, der die einzelnen Strommesswerte $i_{R1}$, $i_{S1}$, $i_{T1}$ bzw. $i_{R2}$, $i_{S2}$, $i_{T2}$ zugeführt werden. Die Auswerteeinrichtung wertet die Stromabtastwerte $i_{R1}$, $i_{S1}$, $i_{T1}$ bzw. $i_{R2}$, $i_{S2}$, $i_{T2}$ unter Anwendung eines Differentialschutzverfahrens aus und erzeugt ein Fehlersignal F, wenn ein interner Fehler, also ein Fehler im Bereich der Komponente 11, festgestellt worden ist. Das Fehlersignal F kann beispielsweise dazu verwendet werden, um ein Auslösesignal für eine Schalteinrichtung, z.B. einen Leistungsschalter, zu erzeugen, mit der die fehlerbehaftete Komponente aus dem übrigen Energieversorgungsnetz abgetrennt wird.

Um die Zuverlässigkeit der Fehlererkennung zu erhöhen, prüft die Auswerteeinrichtung der Differentialschutzeinrichtung 13 außerdem, ob bestimmte Betriebszustände des elektrischen Energieversorgungsnetzes, z.B. ein Einschaltvorgang, vorliegen, die die Durchführung des Differentialschutzverfahrens derart beeinflussen können, dass das Fehlersignal F auch dann erzeugt werden könnte, wenn tatsächlich kein Fehler im Bereich der Komponente 11 vorliegt. Wird ein solcher Betriebszustand des Energieversorgungsnetzes erkannt, so wird das Erzeugen des Fehlersignals F blockiert, um ein fehlerhaftes Auslösen der Differentialschutzeinrichtung 13 zu vermeiden.

In der Figur 2 ist beispielhaft ein Ablaufschema gezeigt, das ein Ausführungsbeispiel für die Arbeitsweise der Differentialschutzeinrichtung 13 gemäß Figur 1 zeigt. Das Ablaufschema ist hierbei in Form eines Blockschaltbildes dargestellt, die Implementierung des beschriebenen Differentialschutzverfahrens kann jedoch sowohl in Form einer Software als auch einer Hardware als auch einer Kombination aus beiden realisiert werden.

Zunächst werden einem ersten Auswerteschritt 21 die Strommesswerte $i_{R1}$, $i_{S1}$, $i_{T1}$ bzw. $i_{R2}$, $i_{S2}$, $i_{T2}$ zugeführt. Handelt es sich bei der elektrischen Komponente 11 um einen Transformator, so müssen in einem vorgelagerten Schritt die Strommesswerte beider Spannungsseiten des Transformators aufeinander angepasst werden. Hierzu finden in dem Fachmann bekannter Weise eine Spannungsebenenanpassung, eine Schaltgruppenanpassung und ggf. eine Nullstromkorrektur oder -eliminierung statt. In den nachfolgenden Gleichungen sind alle Werte im Verhältnis zum Nennstrom der Komponente (Einheit: p.u.) und zu aufeinanderfolgenden Abtastzeitpunkten n berechnet.

In dem ersten Auswerteschritt 21 werden aus den Strommesswerten wie nachfolgend beschrieben Differenzstromwerte $i_d$ und Stabilisierungsstromwerte $i_r$ gebildet. Die Bildung erfolgt wiederum phasenweise; das nachfolgende Ausführungsbeispiel ist jedoch der Einfachheit halber nur für eine Phase dargestellt.

Die Differenzstromwerte $i_d$ jeder Phase R, S, T werden gemäß Gleichung (1) berechnet:

$$i_d = i_1 - i_2 \, . \qquad\qquad\qquad (1)$$

Hierbei sind für die phasenweise Berechnung anstelle von $i_1$ und $i_2$ wie bereits erwähnt die jeweiligen phasenbezogenen Strommesswerte $i_{R1}$, $i_{S1}$, $i_{T1}$ bzw. $i_{R2}$, $i_{S2}$, $i_{T2}$ einzusetzen.

Die Stabilisierungsstromwerte $i_r$ werden gemäß Gleichung (2) wie folgt bestimmt:

$$i_r = \max\left[\left|i_{r1}\right|; \left|i_{r2}\right|\right]. \qquad (2)$$

Hierbei stehen $i_{r1}$ und $i_{r2}$ für die Stabilisierungsströme an der jeweiligen Messstelle 12a bzw. 12b. Diese werden beispielsweise entsprechend den folgenden Gleichungen (3a) und (3b) bestimmt:

$$i_{r1} = \max\left[\left|i_1\right|; \frac{1}{\omega}\left|i_1'\right|\right], \qquad (3a)$$

$$i_{r2} = \max\left[\left|i_2\right|; \frac{1}{\omega}\left|i_2'\right|\right]. \qquad (3b)$$

Hierbei sind wieder für die phasenweise Berechnung anstelle von $i_1$ und $i_2$ wie die jeweiligen phasenbezogenen Strommesswerte $i_{R1}$, $i_{S1}$, $i_{T1}$ bzw. $i_{R2}$, $i_{S2}$, $i_{T2}$ einzusetzen. Außerdem stehen $i_1'$ und $i_2'$ für die jeweilige erste Ableitung der Strommesswerte und $\omega$ für die Kreisfrequenz des Stroms. Die ersten Ableitungen können beispielsweise unter Verwendung eines Differenzenquotienten bestimmt werden (hier beispielhaft gezeigt für $i_1'$:

$$i_1' = \frac{1}{T_S}\left(i_1(n) - i_1(n-1)\right). \qquad (4)$$

Hierbei steht $T_S$ für die Abtastperiode. In einem nächsten Auswerteschritt 22 werden jeweils Wertepaare aus einem Differenzstromwert und einem zugehörigen, d.h. aus gleichzeitig ermittelten Strommesswerten gebildeten, Stabilisierungsstromwert gebildet und bezüglich ihrer Lage in einem Auslösediagramm überprüft. Liegt das Wertepaar innerhalb eines Auslösebereichs, so wird dies als Hinweis auf einen internen Fehler gewertet und es wird ein entsprechendes Hinweissignal $S_F$ an einen nachfolgenden Auswerteschritt 23 übermittelt. Der nachfolgende Auswerteschritt 23 dient für die Erzeugung des Fehlersignals, wenn das Hinweissignal $S_F$ vorliegt.

Die im Auswerteschritt 21 gebildeten Differenzstromwerte und Stabilisierungsstromwerte werden auch einem Auswerteschritt 24 zugeführt, der sie dazu verwendet, einen Fehlerindikator zu bilden, mit dem überprüft werden kann, ob in einem vergangenen Betrachtungszeitraum $T_1$ ein Anteil der Differenzstromwerte oder ein Anteil der Stabilisierungsstromwerte überwogen hat. Der Fehlerindikator kann beispielsweise wie in Gleichung (5) dargestellt ermittelt werden:

$$J(t) = \frac{1}{T_1} \cdot \int_{t-T_1}^{t}\left(i_{op} - K \cdot i_r\right)dt$$

mit

J(t) :  Fehlerindikator;
t :  Zeit;
$T_1$ :  Länge des vorgegebenen Betrachtungszeitraums;
$i_{op}$ :  aus den Differenzstromwerten gebildeter Auslösestrom;
K :  Anpassungsfaktor zur Anpassung an die Art der elektrischen Komponente;
$i_r$ :  Stabilisierungsstrom.

Der Auslösestrom $i_{op}$ wird in dieser Gleichung direkt oder indirekt aus den Differenzstromwerten ermittelt und kann beispielsweise wie in Gleichung (6) angegeben gebildet werden:

$$i_{op} = \max\left[ |i_d| ; \frac{1}{\omega}|i_d'| \right] .$$

Dabei kann zur Bildung der ersten Ableitung $i_d$' analog zur Vorgehensweise gemäß Gleichung (4) erneut ein Differenzenquotient eingesetzt werden.

Der Anpassungsfaktor K dient zur Anpassung der Bildung des Fehlerindikators J an die Art der elektrischen Komponente und kann beispielsweise im Falle eines Transformators den Wert 0,3 und im Falle eines Generators den Wert 0,7 annehmen. Er dient zur Wichtung der Stabilisierungsstromwerte für den Vergleich mit den Differenzstromwerten bzw. dem daraus gebildeten Auslösestrom. Der exakte Wert des Anpassungsfaktors kann z.B. auch durch Experimente oder Simulationen ermittelt werden.

In einem nachfolgenden Auswerteschritt 25 wird der Fehlerindikator J mit einem Schwellenwert H verglichen. Auch der Schwellenwert H kann in Abhängigkeit von der Art der elektrischen Komponente festgelegt werden; er kann beispielsweise im Falle eines Transformators den Wert 2,0 und im Falle eines Generators den Wert 0,0 annehmen. Der exakte Wert des Schwellenwertes kann z.B. auch durch Experimente oder Simulationen ermittelt werden.

Der Fehlerindikator J wird für jede Phase einzeln gebildet und mit dem Schwellenwert H verglichen. In dem Auswerteschritt 25 wird genau dann ein Blockiersignal B erzeugt, wenn die Fehlerindikatoren aller drei Phasen den Schwellenwert H unterschreiten. Das Blockiersignal B wird dem Auswerteschritt 23 zugeführt. Bei anstehendem Blockiersignal B wird die Erzeugung des Fehlersignals F in dem Auswerteschritt 23 verhindert.

In den nachfolgenden Figuren wird anhand von Diagrammen mit beispielhaften Verläufen von Differenzstromwerten und dem jeweils entsprechenden Fehlerindikator das Verhalten des beschriebenen Differentialschutzverfahrens für verschiedene Szenarien dargestellt.

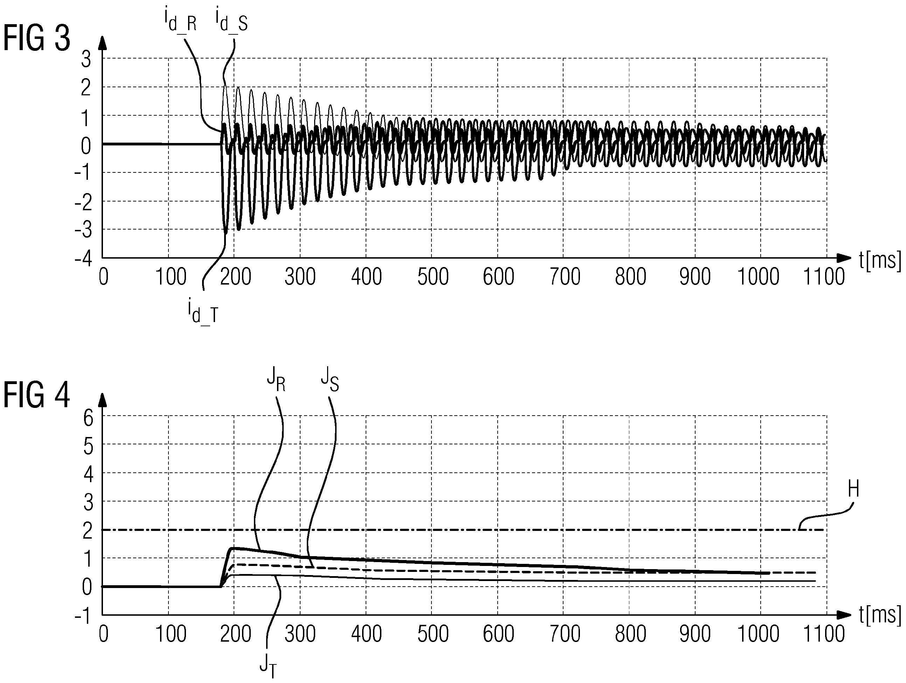

Figuren 3 und 4 betreffen ein erstes Szenario, bei dem ein Einschaltvorgang im elektrischen Energieversorgungsnetz vorliegt. Bei der überwachten Komponente handelt es sich um einen Transformator. In Figur 3 ist dabei der Verlauf der Differenzstromwerte für die einzelnen Phasen dargestellt, während Figur 4 den Verlauf des Fehlerindikators für jede einzelne Phase zeigt. Man erkennt am Diagramm in Figur 3 deutlich, dass nach ca. 700ms aufgrund eines Gleichstromanteils die Stromwandler in Sättigung gehen. Der aufgrund des Einschaltvorgangs und der Wandlersättigung vergleichsweise hohe Differenzstrom würde ohne weitere Stabilisierung zur Erzeugung eines Fehlersignals F führen. Durch die zusätzliche Auswertung des Fehlerindikators J kann hingegen erreicht werden, dass die Erzeugung des Fehlersignals F blockiert wird, da der Fehlerindikator dauerhaft unterhalb des Schwellenwertes H mit dem Wert 2,0 (für Transformatoren) liegt.

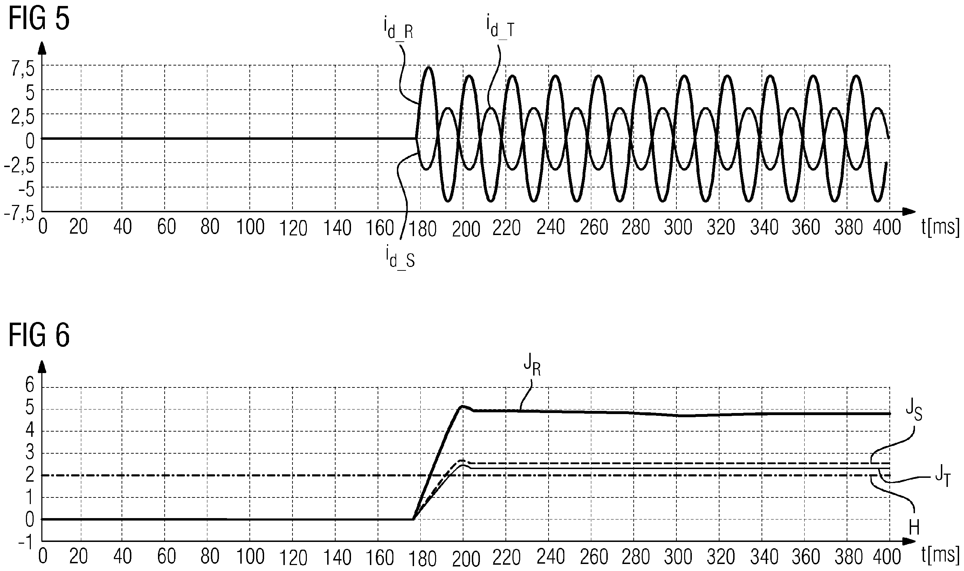

Figuren 5 und 6 betreffen ein zweites Szenario, bei dem ein interner Fehler der Komponente 11 vorliegt. Bei der überwachten Komponente handelt es sich um einen Transformator. In Figur 5 ist dabei der Verlauf der Differenzstromwerte für die einzelnen Phasen dargestellt, während Figur 6 den Verlauf des Fehlerindikators für jede einzelne Phase zeigt. Der vergleichsweise hohe Differenzstrom führt in Kombination mit dem über dem Schwellenwert H mit dem Wert 2,0 liegenden Fehlerindikator J zu einer sicheren Erzeugung des Fehlersignals F.

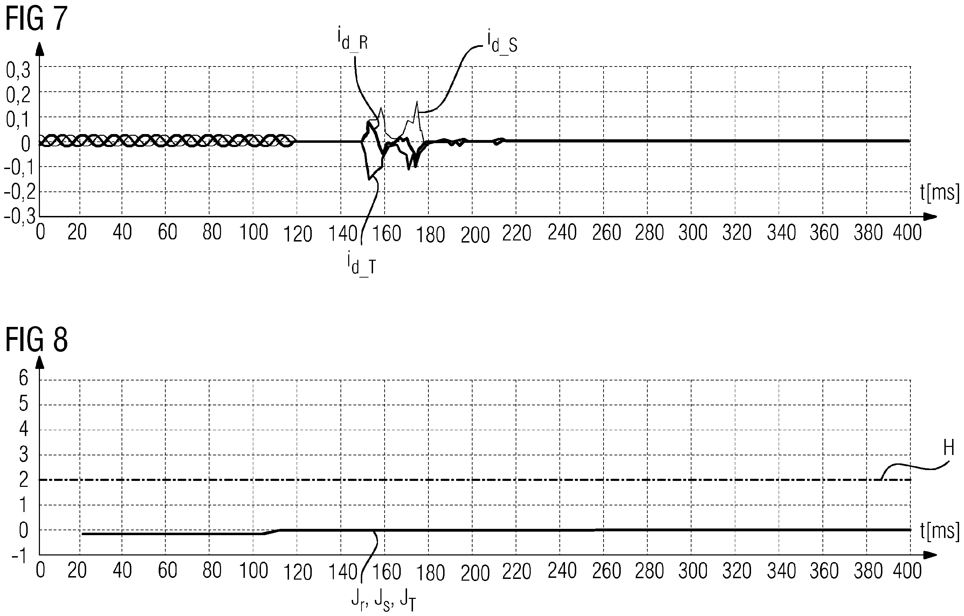

Figuren 7 und 8 betreffen ein drittes Szenario, bei dem ein externer Fehler (außerhalb der Komponente liegender Fehler) vorliegt. Bei der überwachten Komponente handelt es sich um einen Transformator. In Figur 7 ist dabei der Verlauf der Differenzstromwerte für die einzelnen Phasen dargestellt, während Figur 8 den Verlauf des Fehlerindikators für jede einzelne Phase zeigt. Man erkennt am Diagramm in Figur 7 deutlich, dass ca. 60ms nach Fehlereintritt Stromwandlersättigung auftritt. Der aufgrund der Wandlersättigung vergleichsweise hohe Differenzstrom würde ohne weitere Stabilisierung zur Erzeugung eines Fehlersignals F führen. Durch die zusätzliche Auswertung des Fehlerindikators J kann hingegen erreicht werden, dass die Erzeugung des Fehlersignals F blockiert wird, da der Fehlerindikator dauerhaft unterhalb des Schwellenwertes H mit dem Wert 2,0 (für Transformatoren) liegt.

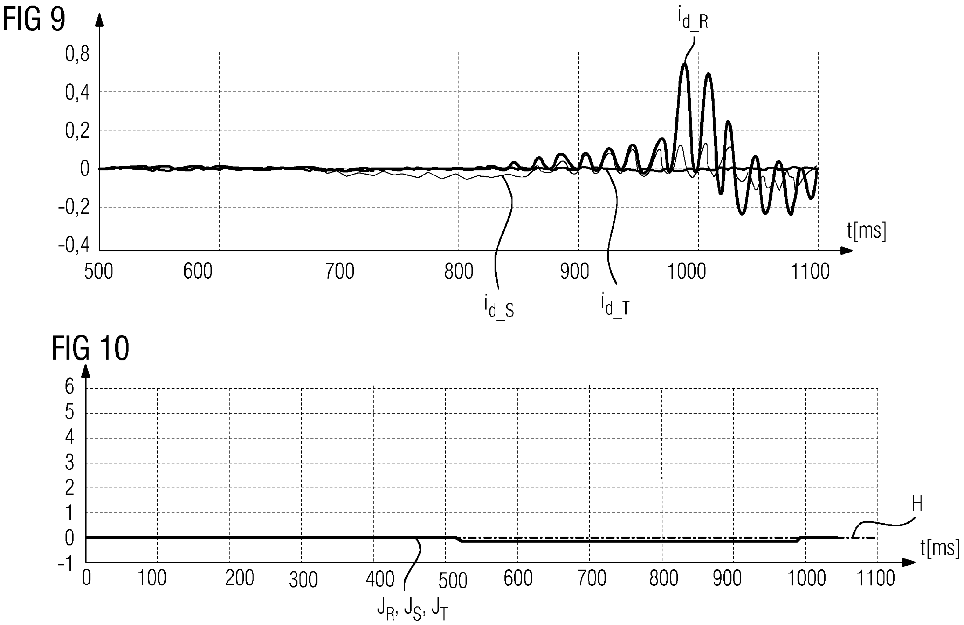

Figuren 9 und 10 betreffen schließlich ein viertes Szenario, bei dem ein generatornaher externer Fehler mit geringem Leiterstrom vorliegt. Bei der überwachten Komponente handelt es sich um einen Generator. In Figur 9 ist dabei der Verlauf der Differenzstromwerte für die einzelnen Phasen dargestellt, während Figur 10 den Verlauf des Fehlerindikators für jede einzelne Phase zeigt. Erneut tritt eine Wandlersättigung aufgrund von vorhandenen Gleichstromanteilen auf. Der vergleichsweise hohe Differenzstrom würde ohne weitere Stabilisierung zur Erzeugung eines Fehlersignals F führen. Durch die zusätzliche Auswertung des Fehlerindikators J kann hingegen erreicht werden, dass die Erzeugung des Fehlersignals F blockiert wird, da zu keinem Zeitpunkt die Fehlerindikatoren aller drei Phasen oberhalb des Schwellenwertes H mit dem Wert 0,0 (für Generatoren) liegt.

**Patentansprüche**

1. Differentialschutzverfahren zum Erzeugen eines Fehlersignals, das einen im Bereich einer elektrischen Komponente (11) eines Energieversorgungsnetzes aufgetretenen Fehler angibt, bei dem

- an mindestens zwei unterschiedlichen Messstellen (12a, 12b) der Komponente jeweils Strommesswerte gemessen werden und mit den Strommesswerten Differenzstromwerte und Stabilisierungswerte gebildet werden, und
- das Fehlersignal erzeugt wird, wenn im Rahmen einer Auslösebereichsprüfung festgestellt wird, dass ein aus einem der Differenzstromwerte und dem jeweils zugehörigen Stabilisierungswert gebildetes Messwertpaar in einem vorgegebenen Auslösebereich liegt,

**dadurch gekennzeichnet, dass**

- die in einem vorgegebenen Betrachtungszeitraum liegenden Stabilisierungsstromwerte mit den jeweils zugehörigen Differenzstromwerten verglichen werden und anhand des Vergleichs ein Fehlerindikator gebildet wird, der angibt, ob der Anteil der Differenzstromwerte oder der Anteil der Stabilisierungsstromwerte überwiegt; und
- die Erzeugung des Fehlersignals blockiert wird, wenn der Fehlerindikator einen überwiegenden Anteil der Stabilisierungsstromwerte angibt.

2. Differentialschutzverfahren nach Anspruch 1,
   **dadurch gekennzeichnet, dass**

   - zur Bildung des Fehlerindikators das integrale Mittel aus unter Verwendung der Differenzstromwerte und der Stabilisierungsstromwerte gebildeten Differenzen bestimmt wird.

3. Differentialschutzverfahren nach Anspruch 1 oder 2,
   **dadurch gekennzeichnet, dass**

   - dass als elektrische Komponente (11) ein Transformator oder ein Generator verwendet wird.

4. Differentialschutzverfahren nach Anspruch 3,

   - der Fehlerindikator in Abhängigkeit von der Art der elektrischen Komponente (11) unterschiedlich bestimmt wird.

5. Differentialschutzverfahren nach einem der vorangehenden Ansprüche,
   **dadurch gekennzeichnet, dass**

   - der Fehlerindikator mit einem vorgegebenen Schwellenwert verglichen wird; und
   - die Erzeugung des Fehlersignals blockiert wird, wenn der Fehlerindikator den Schwellenwert unterschreitet.

6. Differentialschutzverfahren nach Anspruch 5,

   - der Schwellenwert in Abhängigkeit von der Art der elektrischen Komponente (11) unterschiedlich festgelegt wird.

7. Differentialschutzverfahren nach einem der vorangehenden Ansprüche,
   **dadurch gekennzeichnet, dass**

   - der Fehlerindikator unter direkter Verwendung der Differenzstromwerte oder unter Verwendung von den Differenzstromwerten abgeleiteter Werte bestimmt wird.

8. Differentialschutzverfahren nach einem der vorangehenden Ansprüche,
   **dadurch gekennzeichnet, dass**

   - der Fehlerindikator wie folgt gebildet wird:

$$J(t) = \frac{1}{T_1} \cdot \int_{t-T_1}^{t} \left( i_{op} - K \cdot i_r \right) dt$$

mit

J(t) : Fehlerindikator;
t : Zeit;
$T_1$ : vorgegebener Betrachtungszeitraum;
$i_{op}$ : aus den Differenzstromwerten gebildeter Auslösestrom;
K : Anpassungsfaktor zur Anpassung an die Art der elektrischen Komponente;
$i_r$ : Stabilisierungsstrom.

9. Differentialschutzverfahren nach einem der vorangehenden Ansprüche,
   **dadurch gekennzeichnet, dass**

   - der Fehlerindikator für jede Phase einer mehrphasigen elektrischen Komponente bestimmt wird; und
   - die Erzeugung des Fehlersignals nur dann blockiert wird, wenn die Fehlerindikatoren für alle Phasen den vorgegebenen Schwellenwert unterschreiten.

10. Differentialschutzeinrichtung (13) mit

    - einer Messwerterfassungseinrichtung zur Erfassung von an unterschiedlichen Stellen einer elektrischen Komponente (13) eines Energieversorgungsnetzes ermittelten Strommesswerten; und
    - einer Auswerteeinrichtung, die zur Bildung von Differenzstromwerten und Stabilisierungswerten aus den Strommesswerten und zur Erzeugung eines Fehlersignals eingerichtet ist, wenn im Rahmen einer Auslösebereichsprüfung festgestellt wird, dass ein aus einem der Differenzstromwerte und dem jeweils zugehörigen Stabilisierungswert gebildetes Messwertpaar in einem vorgegebenen Auslösebereich liegt;

    **dadurch gekennzeichnet, dass**

    - die Auswerteeinrichtung auch dazu eingerichtet ist, die in einem vorgegebenen Betrachtungszeitraum liegenden Stabilisierungsstromwerte mit den jeweils zugehörigen Differenzstromwerten zu vergleichen und anhand des Vergleichs einen Fehlerindikator zu bilden, der angibt, ob der Anteil der Differenzstromwerte oder der Anteil der Stabilisierungsstromwerte überwiegt, und die Erzeugung des Fehlersignals zu blockieren, wenn der Fehlerindikator einen überwiegenden Anteil der Stabilisierungsstromwerte angibt.

11. Differentialschutzeinrichtung (13) nach Anspruch 10,
    **dadurch gekennzeichnet, dass**

    - die Auswerteeinrichtung dazu eingerichtet ist, zur Bildung des Fehlerindikators das integrale Mittel aus unter Verwendung der Differenzstromwerte und der Stabilisierungsstromwerte gebildeten Differenzen zu bestimmen.

12. Differentialschutzeinrichtung (13) nach Anspruch 10 oder 11,
    **dadurch gekennzeichnet, dass**

    - die Auswerteeinrichtung dazu eingerichtet ist, den Fehlerindikator mit einem vorgegebenen Schwellenwert zu vergleichen; und
    - die Erzeugung des Fehlersignals zu blockieren, wenn der Fehlerindikator den Schwellenwert unterschreitet.

**Claims**

1. Differential protection method for generating a fault signal which indicates a fault occurring in the area of an electrical component (11) of an electrical power supply system, in which

   - current measurement values are measured at each of at least two different measurement locations (12a, 12b) of the component, and differential current values and stabilization values are formed via the current measurement values, and
   - the fault signal is generated if, within the scope of a triggering range test, it is detected that a measurement value pair formed from one of the differential current values and the associated stabilization value in each case lies in a predefined triggering range,

**characterized in that**

- the stabilization current values in a predefined observation time period are compared with the associated differential current values in each case, and on the basis of the comparison, a fault indicator is formed which indicates whether the proportion of the differential current values or the proportion of the stabilization current values predominates; and
- the generation of the fault signal is blocked if the fault indicator indicates a predominant proportion of the stabilization current values.

2. Differential protection method according to Claim 1, **characterized in that**

- for the formation of the fault indicator, the integral mean value is determined from differences formed through the use of the differential current values and the stabilization current values.

3. Differential protection method according to Claim 1 or 2, **characterized in that**

- a transformer or a generator is used as an electrical component (11).

4. Differential protection method according to Claim 3, **characterized in that**

- the fault indicator is determined differently as a function of the type of electrical component (11).

5. Differential protection method according to one of the preceding claims, **characterized in that**

- the fault indicator is compared with a predefined threshold value; and
- the generation of the fault signal is blocked if the fault indicator falls below the threshold value.

6. Differential protection method according to Claim 5, **characterized in that**

- the threshold value is determined differently as a function of the type of electrical component (11).

7. Differential protection method according to one of the preceding claims, **characterized in that**

- the fault indicator is determined through the direct use of the differential current values or through the use of values derived from the differential current values.

8. Differential protection method according to one of the preceding claims, **characterized in that**

- the fault indicator is formed as follows:

$$J(t) = \frac{1}{T_1} \cdot \int_{t-T_1}^{t} \left( i_{op} - K \cdot i_r \right) dt$$

where

J(t): fault indicator;
t: time;
$T_1$: predefined observation time period;
$i_{op}$: triggering current formed from the differential current values;
K: adjustment factor for adjusting to the type of electrical component;
$i_r$: stabilization current.

9. Differential protection method according to one of the preceding claims,

**characterized in that**

- the fault indicator is determined for each phase of a multiphase electrical component; and
- the generation of the fault signal is then blocked only if the fault indicators for all phases fall below the predefined threshold value.

10. Differential protection device (13) including

- a measurement value detection device for detecting current measurement values determined at different locations of an electrical component (13) of an electrical power supply system; and
- an analysis device which is configured for the formation of differential current values and stabilization values from the current measurement values and for generating a fault signal, if it is determined within the scope of a triggering range test that a measurement value pair formed from one of the differential current values and the associated stabilization value in each case lies in a predefined triggering range; **characterized in that**
- the analysis device is also configured to compare the stabilization current values in a predefined observation time period with the associated differential current values in each case, and based on the comparison, to form a fault indicator which indicates whether the proportion of the differential current values or the proportion of the stabilization current values predominates, and to block the generation of the fault signal if the fault indicator indicates a predominant proportion of the stabilization current values.

11. Differential protection device (13) according to Claim 10,
**characterized in that**

- the analysis device is configured to determine the integral mean value from differences formed through the use of the differential current values and the stabilization current values for the formation of the fault indicator.

12. Differential protection device (13) according to Claim 10 or 11,
**characterized in that**

- the analysis device is configured to compare the fault indicator with a predefined threshold value; and
- to block the generation of the fault signal if the fault indicator falls below the threshold value.

**Revendications**

1. Procédé de protection différentiel pour produire un signal de défaut, qui indique un défaut apparu dans la partie d'un composant (11) électrique d'un réseau d'alimentation en énergie, dans lequel

- on mesure, en au moins deux points (12a, 12b) de mesure différents du composant, des valeurs de mesure du courant et on forme, avec les valeurs de mesure du courant, des valeurs de courant de différence et des valeurs de stabilisation et
- on produit le signal de défaut si l'on constate, dans le cadre d'un contrôle d'une plage de déclenchement, qu'une paire de valeurs de mesure, formée de l'une des valeurs de courant de différence et de la valeur de stabilisation associée, se trouve dans une plage de déclenchement donnée à l'avance,

**caractérisé en ce que**

- on compare les valeurs de courant de stabilisation se trouvant dans un laps de temps de considération donné à l'avance aux valeurs de courant de différence associées et, à l'aide de la comparaison, on forme un indicateur de défaut, qui indique si la proportion des valeurs de courant de différence ou la proportion des valeurs de courant de stabilisation est prépondérante et
- on bloque la production du signal de défaut si l'indicateur de défaut indique une proportion prépondérante des valeurs de courant de stabilisation.

2. Procédé de protection différentiel suivant la revendication 1,
**caractérisé en ce que**

- pour former l'indicateur de défaut, on détermine la moyenne intégrale en utilisant les différences formées des valeurs de courant de différence et des valeurs de courant de stabilisation.

**3.** Procédé de protection différentiel suivant la revendication 1 ou 2,
   **caractérisé en ce que**

   - on utilise comme composant (11) électrique un transformateur ou un alternateur.

**4.** Procédé de protection différentiel suivant la revendication 3,
   **caractérisé en ce que**

   - on détermine différemment l'indicateur de défaut en fonction du type du composant (11) électrique.

**5.** Procédé de protection différentiel suivant l'une des revendications précédentes,
   **caractérisé en ce que**

   - on compare l'indicateur de défaut à une valeur de seuil donnée à l'avance et
   - on bloque la production du signal de défaut si l'indicateur de défaut est inférieur à la valeur de seuil.

**6.** Procédé de protection différentiel suivant la revendication 5,

   - en ce que l'on fixe différemment la valeur de seuil en fonction du type du composant (11) électrique.

**7.** Procédé de protection différentiel suivant l'une des revendications précédentes,
   **caractérisé en ce que**

   - on détermine l'indicateur de défaut en utilisant directement les valeurs de courant de différence ou en utilisant des valeurs déduites des valeurs de courant de différence.

**8.** Procédé de protection différentiel suivant l'une des revendications précédentes,
   **caractérisé en ce que**

   - on forme l'indicateur de défaut de la manière suivants :

$$J(t) = \frac{1}{T_1} \cdot \int_{t-T_1}^{t} \left( i_{op} - K \cdot i_r \right) dt$$

avec

   J(t) : indicateur de défaut ;
   t : temps ;
   $T_1$ : laps de temps de considération donné à l'avance ;
   $i_{op}$ : valeur de déclenchement formée à partir des valeurs de courant de différence ;
   K : facture d'adaptation pour s'adapter au type du composant électrique ;
   $i_r$ : courant de stabilisation.

**9.** Procédé de protection différentiel suivant l'une des revendications précédentes,
   **caractérisé en ce que**

   - on détermine l'indicateur de défaut pour chaque phase d'un composant électrique polyphasé et
   - on ne bloque la production du signal de défaut que si les indicateurs de défaut sont inférieurs, pour toutes les phases, à la valeur de seuil donnée à l'avance.

**10.** Dispositif (13) de protection différentiel, comprenant

   - un dispositif de détection de valeurs de mesure pour détecter des valeurs de mesure du courant, déterminées en des points différents d'un composant (13) électrique d'un réseau d'alimentation en énergie et
- un dispositif d'exploitation conçu pour former des valeurs de courant de différence et des valeurs de stabilisation à partir des valeurs de mesure du courant et pour produire un signal de défaut si, dans le cadre d'un contrôle de plage de déclenchement, on constate qu'une paire de valeurs de mesure, formée à partir de l'une des valeurs de courant de différence et de la valeur de stabilisation associée, se trouve dans une plage de déclenchement donnée à l'avance ;

**caractérisé en ce que**

- le dispositif d'exploitation est conçu également pour comparer les valeurs de courant de stabilisation se trouvant dans un laps de temps de considération donné à l'avance aux valeurs de courant de différence associées et, à l'aide de la comparaison, pour former un indicateur de défaut, qui indique si la proportion des valeurs de courant de différence ou la proportion des valeurs de courant de stabilisation est prépondérante et, pour bloquer la production du signal de défaut, si l'indicateur de défaut indique une proportion prépondérante des valeurs de courant de stabilisation.

**11.** Dispositif (13) de protection différentiel suivant la revendication 10,
**caractérisé en ce que**

- le dispositif d'exploitation est conçu pour, afin de former l'indicateur de défaut, déterminer la moyenne intégrale de différences formées en utilisant les valeurs de courant de différence et les valeurs de courant de stabilisation.

**12.** Dispositif (13) de protection différentiel suivant la revendication 10 ou 11,
**caractérisé en ce que**

- le dispositif d'exploitation est conçu pour comparer l'indicateur de défaut à une valeur de seuil donnée à l'avance et
- bloquer la production du signal de défaut si l'indicateur de défaut est inférieur à la valeur de seuil.

FIG 1

FIG 2

FIG 3

$i_{d\_R}$  $i_{d\_S}$

$i_{d\_T}$

FIG 4

$J_R$  $J_S$

H

$J_T$

EP 3 108 554 B1

## FIG 5

## FIG 6

EP 3 108 554 B1

FIG 7

FIG 8

FIG 9

$i_{d\_R}$

$i_{d\_S}$

$i_{d\_T}$

FIG 10

$J_R, J_S, J_T$

H

**EP 3 108 554 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5808844 A

- WO 2010034635 A1

**In der Beschreibung aufgeführte Nicht-Patentliteratur**

- **HE B. ; ZHANG X. ; BO Z.** A new method to identify inrush current based on error estimation. *IEEE Transactions on Power Delivery,* Juli 2006, vol. 21 (3), 1163-1168

- **KASZTENNY, B. ; ROSOLOWSKI, E ; SAHA, M.M. ; HILLSTROM, B.** A self-organizing fuzzy logic based protective relay-an application to power transformer protection. *IEEE Transactions on Power Delivery,* Juli 1997, vol. 12 (3), 119-1127